# EUROPÄISCHE PATENTSCHRIFT

(11) **EP 1 870 970 B1**
(45) Veröffentlichungstag und Bekanntmachung des Hinweises auf die Patenterteilung: **09.02.2011**
(21) Anmeldenummer: 07008811.7
(22) Anmeldetag: 02.05.2007
(51) Int. Cl.: H01R 43/24, B29C 45/14, H05K 3/20

(54) **Verfahren zur Herstellung eines elektrischen Hybridbauteils**
Method for manufacturing an electric hybrid component
Procédé de fabrication d'un composant hybride électrique

(30) Priorität: 21.06.2006 DE 102006028815
(43) Veröffentlichungstag der Anmeldung: 26.12.2007
(73) Patentinhaber: hansatronic GmbH, 78052 Villingen-Schwenningen (DE)
(72) Erfinder: Huonker, Hans-Georg, 78052 Villingen-Schwenningen (DE)

(56) Entgegenhaltungen:
- EP-A- 1 170 110
- DE-A1- 4 407 508
- DE-A1- 19 640 255
- DE-A1-102004 044 614
- US-A1- 2003 205 788
- US-B1- 6 248 424

## Beschreibung

Die Erfindung betrifft ein Verfahren zur Herstellung eines elektrischen Hybridbauteils, welches als elektrische Leiter aus einem Stanzgitter ausgestanzte Verbindungselemente aufweist. Solche Hybridbauteile sind bereits aus dem Stand der Technik bekannt. Diese Verbindungselemente sind beim fertigen Hybridbauteil in ein umspritztes Kunststoffgehäuse eingebettet. Um zu verhindern, dass die Verbindungselemente während des Umspritzens ihre vorgegebene Position verlassen, sind diese einerseits untereinander über Stabilisierungsstege und andererseits mit dem Stanzgitter über Haltestege feststehend verbunden.

Verfahren zur Herstellung von elektrischen Hybridbauteilen beispielsweise in Form von elektrischen Steckbauteilen oder Steckerverbindungen sind beispielsweise aus der DE 10 2004 044 614.8 bekannt. In dieser Druckschrift geht es im wesentlichen um das Umspritzen von Hybridbauteilen, welche insbesondere elektronische Bauteile enthalten, die umspritzt werden sollen.

Unter einem Hybridbauteil ist gemäß dieser Druckschrift ein Bauteil zu verstehen, welches aus verschiedenen Werkstoffen, insbesondere Metall und Kunststoff besteht. Zur Herstellung solcher Hybridbauteile werden sogenannte Stanzgitter verwendet, welche aus einem bandförmigen Blechteil hergestellt werden. Aus diesem bandförmigen Blechteil werden durch entsprechende Stanz- und Biegevorgänge die elektrischen Verbindungselemente des Hybridbauteils hergestellt, welche untereinander und mit dem restlichen Blechteil über Stabilisierungsstege bzw. Haltestege in Verbindung bleiben, so dass danach das eigentliche Stanzgitter vorliegt. Das heißt, dass es sich bei dem Stanzgitter um ein Blechband handelt, das vorgestanzte Verbindungselemente enthält, welche später zum fertigen Hybridbauteil umspritzt werden. Speziell die Herstellung eines solchen Stanzgitters mit den erwähnten Stabilisierungsstegen ist beispielsweise in der DD 254 840 A1 beschrieben.

Aus der DE 10 2004 044 614.8 ist es weiter bekannt, dass die einzelnen Verbindungselemente nach dem Stanzvorgang im bandförmigen Stanzgitter hintereinander liegend eingebunden sind. Die gestanzten Verbindungselemente stehen, um beim späteren Spritzgussvorgang präzise gegeneinander positioniert zu sein, über Stabilisierungsstege miteinander in Verbindung. Des weiteren sind nach dem Stanzen die Verbindungselemente über Haltestege mit dem Stanzgitter bzw. dem restlichen Blechband feststehend verbunden.

Beim Stand der Technik werden nun diese Haltestege vor dem Spritzgussvorgang getrennt, so dass die noch miteinander verbundenen Verbindungselemente als separates Einzelteil vorliegen. Dieses Einzelteil wird nun mittels einer entsprechenden Handhabungseinrichtung beispielsweise einer Horizontalspritzgussmaschine zugeführt und dort auf deren Düsenseite eingelegt. Nach dem Schließen der Spritzgussform wird nun das Blechteil mit Kunststoff umspritzt, so dass die Verbindungselemente in einem entstehenden Kunststoffgehäuse eingebettet sind und zusammen mit diesem das Hybridbauteil bilden.

Nach dem Umspritzen wiederum wird das Hybridbauteil mit seinem Kunststoffgehäuse und den noch miteinander in Verbindung stehenden Verbindungselementen aus der Spritzgussmaschine entnommen und einer Trenn- oder Stanzeinrichtung zugeführt. Diese Trenn- oder Stanzeinrichtung weist entsprechende Trennwerkzeuge auf, mittels welcher die Stabilisierungsstege zwischen den Verbindungselementen durch Stanzen getrennt werden. Dieser Trennvorgang ist notwendig, um in einem weiteren Verfahrensschritt das Hybridbauteil bzw. dessen Verbindungselemente einer Spannungsprüfung unterziehen zu können. Dazu ist eine weitere Prüfstation vorgesehen, in welcher das Hybridbauteil auf Spannungsüberschläge geprüft wird.

Aus der EP 1 170 110 A1 ist beispielsweise ein Verfahren bekannt, bei welchem die durch Stanzen hergestellten, separierten Verbindungselemente mit ihren Stabilisierungsstegen in eine Spritzgussform eingelegt werden. Das heißt, dass auch die Verbindungselemente vor dem Spritzgießen über die Stabilisierungsstege feststehend miteinander in Verbindung stehen, um beim Spritzgussvorgang ihre gewünschte Lage beizubehalten. Vor dem Spritzgießen werden die Verbindungselemente aus dem bandförmigen Stanzgitter herausgelöst, so dass diese in die Spritzgussform eingelegt werden können. Durch anschließendes Umspritzen entsteht so ein Hybridbauteil, bestehend aus den Verbindungselementen und dem beim Umspritzen erzeugten Kunststoffgehäuse. Nach dem Umspitzen können auch hier die Stabilisierungsstege entfallen, da die Verbindungselemente durch den umspritzten Kunststoff gehalten werden.

Weiter ist aus der US 2003/0205788 A1 ein Verfahren zur Herstellung eines Hybridbauteils bekannt, bei welchem die Verbindungselemente ebenfalls einerseits untereinander und andererseits mit einem äußeren "Führungsrahmen" in Verbindung stehen. Hierbei bilden die Verbindungselemente und der Führungsrahmen ein einzelnes Bauteil. Der Führungsrahmen weist mehrere nach innen zu den Verbindungselementen hin gerichtete "Beine" auf, welche jeweils einen Abstand zu den Verbindungselementen aufweise. Der Führungsrahmen dient hier dazu, die mit dem Führungsrahmen in Verbindung stehenden Verbindungselemente mittels einer Handhabungseinrichtung einer Spritzgießmaschine zum Anspritzen eines Kunststoffgehäuses zuzuführen. Die Größe des angespritzten Gehäuses ist dabei so gewählt, dass nach dem Spritzgussvorgang ein "leichte" Verbindung mit den inneren Enden der Beine des Führungsrahmens entsteht. Nach dem Anspritzen des Gehäuses werden nun die Verbindungen zwischen den Verbindungselementen und dem Führungsrahmen entfernt, wobei die Beine des Führungsrahmen erhalten bleiben. Damit kann dieses "Zwischenprodukt" über den Führungsrahmen weiteren Bearbeitungsschritten zugeführt werden. In einem letzten Schritt kann das Gehäuse zusammen mit den eingebetteten Verbindungselementen durch eine leichte Verformung des Führungsrahmens aus diesem entfernt werden, da zwischen den Beinen und dem Gehäuse lediglich eine leichte Verbindung besteht. Aufgrund der oben insbesondere zur DE 10 2004 044 614.8 beschriebenen Verfahrensschritte zur Herstellung eines solchen elektrischen Steckmoduls oder Hybridbauteils ist deren Herstellung äußerst aufwändig. Insbesondere sind hierzu auch besondere Handhabungseinrichtungen wie beispielsweise Industrieroboter notwendig, um die einzelnen Zwischenprodukte von einer Arbeitsstation zur nächsten transportieren zu können.

Der Erfindung liegt demgemäß die Aufgabe zugrunde, ein Verfahren zur Herstellung eines Hybridbauteils anzugeben, bei welchem die einzelnen Herstellungsschritte in einem kontinuierlichen Arbeitsablauf aufeinanderfolgen.

Die Aufgabe wird erfindungsgemäß durch die Merkmale des Patentanspruches 1 gelöst.

Durch das erfindungsgemäße Verfahren wird ein kontinuierlicher Produktionsprozess ermöglicht, in welchem das Stanzgitter mit den Verbindungselementen in aufeinander folgenden, kontinuierlich ablaufenden Verfahrensschritten unterschiedlichen Herstellungsprozessen zuführbar ist.

Dazu ist vorgesehen, dass die untereinander in Verbindung stehenden Verbindungselemente über die Haltestege während des Umspritzens am Stanzgitter verbleiben. Dabei werden während des Umspritzvorganges zwischen dem Kunststoffgehäuse und dem Stanzgitter Kunststoffbrücken angespritzt, so dass auch nach dem Trennvorgang der Haltestege zwischen dem Stanzgitter und den Verbindungselementen eine zusätzliche Verbindung verbleibt. Damit können das Kunststoffgehäuse und die darin eingebetteten Verbindungselemente zusammen mit dem Stanzgitter weiteren Verfahrensschritten des Herstellungsprozesses zugeführt werden, ohne dass ein Industrieroboter oder dgl. notwendig ist.

Weitere vorteilhafte Ausgestaltungen des Verfahrens sind den Unteransprüchen zu entnehmen.

So ist gemäß Anspruch 2 vorgesehen, dass die Kunststoffbrücken im Bereich der Haltestege angespritzt werden. Hierdurch ist sichergestellt, dass die Kunststoffbrücken einstückig am Kunststoffgehäuse des Hybridbauteils angeformt sind und somit eine unbeabsichtigte Trennung der Kunststoffbrücken vom Kunststoffgehäuse des Hybridbauteils sicher ausgeschlossen ist.

Gemäß Anspruch 3 kann weiter vorgesehen sein, dass das Stanzgitter zusammen mit dem aus den Verbindungselementen und dem Kunststoffgehäuse bestehenden Hybridbauteil einer Trenn- oder Stanzeinrichtung zugeführt wird und, dass durch die Trenn- oder Stanzeinrichtung die Haltestege elektrisch getrennt werden. Hier ist durch die vorgesehenen Kunststoffbrücken zwischen dem Stanzgitter und dem Kunststoffgehäuse des Hybridbauteils sichergestellt, dass auch nach der Trennung der Haltestege das Hybridbauteil sicher am Stanzgitter verankert bleibt und somit auch nach der Trennung weiteren Herstellungsprozessen mit dem Stanzgitter zuführbar ist.

Weiter ist gemäß Anspruch 4 vorgesehen, dass durch die Trenn- oder Stanzeinrichtung die Verbindungselemente durch Trennung der Stabilisierungsstege voneinander elektrisch getrennt werden. Damit ist nun das Hybridbauteil für eine Spannungsprüfung vorbereitet, da auch deren Verbindungselemente elektrisch voneinander getrennt sind.

Vorzugsweise können die Verfahrensschritte der Ansprüche 3 und 4 gemäß Anspruch 5 gleichzeitig erfolgen, so dass ein separater Herstellungsschritt der Trennvorgänge entfällt.

Gemäß Anspruch 6 ist vorgesehen, dass das Stanzgitter zusammen mit dem Hybridbauteil einer elektrischen Spannungsprüfeinrichtung zugeführt wird, in welcher das Hybridbauteil auf Spannungsüberschläge geprüft wird. Auch bei diesem Herstellungs- bzw. Verfahrensschritt wird das Hybridbauteil zusammen mit dem bandförmigen Stanzgitter transportiert, so dass auch hierzu keinerlei Industrieroboter oder dgl. notwendig ist.

In einem letzten Verfahrensschritt kann nun gemäß Anspruch 7 durch einen weiteren Stanz- oder Trennvorgang das Hybridbauteil beispielsweise durch Abscheren der Kunststoffbrücken aus dem Stanzgitter herausgetrennt werden, so dass anschließend das fertige Hybridbauteil vorliegt. Eine weitere Zuführung des Hybridbauteils beispielsweise zur elektrischen Spannungsprüfung ist nun nicht mehr notwendig, da dies bereits vorab geschehen ist.

Es ist erkennbar, dass durch die zusätzlich angespritzten Kunststoffbrücken das Hybridbauteil im Stanzgitter verbleibt und somit in einem kontinuierlichen Prozess zunächst zusammen mit dem Stanzgitter einer Trenn- oder Stanzeinrichtung zuführbar ist, durch welche einerseits die Stabilisierungsstege zwischen den Verbindungselementen und andererseits die Haltestege zwischen den Verbindungselementen und dem Stanzgitter trennbar sind. Da das so hergestellte Hybridbauteil nun über die Kunststoffbrücken weiter im Stanzgitter verbleibt, kann dieses zusammen mit dem Hybridbauteil einer Spannungsprüfeinrichtung in einem weiteren kontinuierlichen Prozess zugeführt werden. Nach Abschluss dieser Spannungsprüfung sind nun als letzter Verfahrensschritt letztendlich nur noch die Kunststoffbrücken abzutrennen, so dass das fertig geprüfte Hybridbauteil vorliegt.

Anhand der Zeichnung wird nachfolgend der Verfahrensablauf anhand eines Ausführungsbeispiels eines Hybridbauteils näher erläutert. Es zeigt:
- Fig. 1: Eine Draufsicht auf einen Ausschnitt eines Stanzgitters mit bereits fertig gestanzten und evtl. gebogenen Verbindungselementen, welche einerseits über Stabilisierungsstege untereinander und andererseits über Haltestege mit dem Stanzgitter in Verbindung stehen sowie bereits mit einem Kunststoffgehäuse umspritzte Verbindungselemente, bei welchen im Bereich der Haltestege zusätzliche Kunststoffbrücken als Verbindung zwischen dem Kunststoffgehäuse und dem Stanzgitter vorgesehen sind;
- Fig. 2: einen vergrößerten Ausschnitt II aus Fig. 1 mit den Haltestegen als Verbindung zwischen den Verbindungselementen und dem Stanzgitter und zusätzlich angespritzten Kunststoffbrücken, durch welche das angespritzte Kunststoffgehäuse mit dem Stanzgitter in Verbindung steht;
- Fig. 3: die Verbindung aus Fig. 2 in Unteransicht;
- Fig. 4: einen Teilschnitt IV-IV aus Fig. 1 und Fig. 2, aus welchem der umspritzte Kunststoffkörper einerseits und andererseits die angespritzten Kunststoffbrücken im Schnitt erkennbar sind;
- Fig. 5: die Darstellung aus Fig. 4 nach dem Durchtrennen der Stabilisierungsstege und der Haltestege.

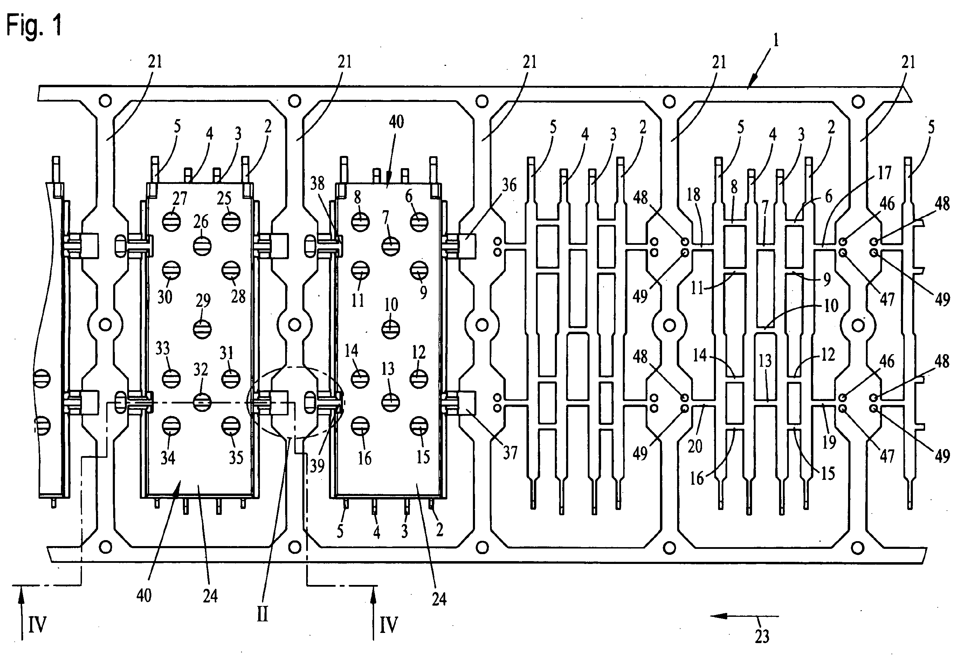

Fig. 1 zeigt eine Draufsicht auf ein Stanzgitter 1, welches bereits vorgestanzt bzw. vorgebogen ist. Dieses Stanzgitter 1 wird, wie dies aus dem Stand der Technik bekannt ist, aus einem Blechteil oder Blechband hergestellt. In einem Stanzvorgang werden aus diesem Blechband mehrere Verbindungselemente 2, 3, 4, 5 ausgestanzt, welche miteinander über mehrere Stabilisierungsstege 6, 7, 8, 9, 10, 11, 12, 13, 14, 15 und 16 in Verbindung stehen. Diese Einheit aus den Verbindungselementen 2 bis 5 und den Stabilisierungsstegen 6 bis 16 steht über mehrere Haltestege 17, 18, 19 und 20 beispielsweise mit quer verlaufenden Quertraversen 21 des Stanzgitters 1 in Verbindung. Somit sind die Gruppen von Verbindungselementen 2 bis 5 durch Transport des Stanzgitters 1 in Richtung des Pfeiles 23 verschiedenen nachfolgenden Produktionsprozessen in einem kontinuierlichen Vorgang zuführbar.

In Fig. 1 sind dabei in der rechten Bildhälfte zwei solcher Gruppen von Verbindungselementen 2 bis 5 dargestellt, welche identisch ausgebildet sind und auch zur Herstellung von identischen Hybridbauteilen entsprechend der Darstellung vorgestanzt und evtl. vorgebogen sind.

Nach dem ersten Verfahrensschritt des Ausstanzens des Stanzgitters 1 und der Herstellung der Verbindungselemente 2 bis 5 mit ihren Stabilisierungsstegen 6 bis 16 sowie den Haltestegen 17 bis 20 folgt nun ein Umspritzen der Verbindungselemente 2 bis 5 in einer Spritzgussmaschine, welche in der Zeichnung nicht näher dargestellt ist. Dabei wird das Stanzgitter 1 mit einer Gruppe von Verbindungselementen 2 bis 5 in den Bereich einer entsprechenden Spritzgusskavität transportiert, in welcher um die Verbindungselemente 2 bis 5 ein Kunststoffgehäuse 24 angespritzt wird, wie dies für die beiden linken Gruppen von Verbindungselementen 2 bis 5 in Fig. 1 beispielhaft dargestellt ist.

Dieses Kunststoffgehäuse 24 umschließt dabei die Verbindungselemente 2 bis 5, wobei die Stabilisierungsstege 6 bis 16 nicht mit umspritzt werden. Hier sind, wie dies aus Fig. 1 ersichtlich ist, jeweils Durchbrüche 25, 26, 27, 28, 29, 30, 31, 32, 33, 34 und 35 ausgespart, so dass in einem späteren Verfahrensabschnitt die Stabilisierungsstege 6 bis 16 in einem Stanz- bzw. Trennvorgang ausgestanzt werden können. Der Übersichtlichkeit halber sind im linken Kunststoffgehäuse 24 die Durchbrüche 25 bis 35 und im rechten Kunststoffgehäuse 24 der Fig. 1 die zugehörigen Stabilisierungsstege 6 bis 16 mit den zugehörigen Bezugszeichen gekennzeichnet.

Des weiteren ist aus Fig. 1 ersichtlich, dass dem Kunststoffgehäuse 24 im Bereich der Haltestege 17 bis 20 zusätzliche Kunststoffbrücken 36, 37, 38 und 39 angespritzt sind, welche beim rechten Kunststoffgehäuse 24 mit Bezugszeichen versehen sind. Dabei sind die Kunststoffbrücken 36 und 37 und die Kunststoffbrücken 38 und 39 identisch ausgebildet. Es können auch alle Kunststoffbrücken 36 bis 39 identisch ausgebildet sein, wobei die hier dargestellten Ausführungsformen lediglich beispielhaft zu verstehen sind.

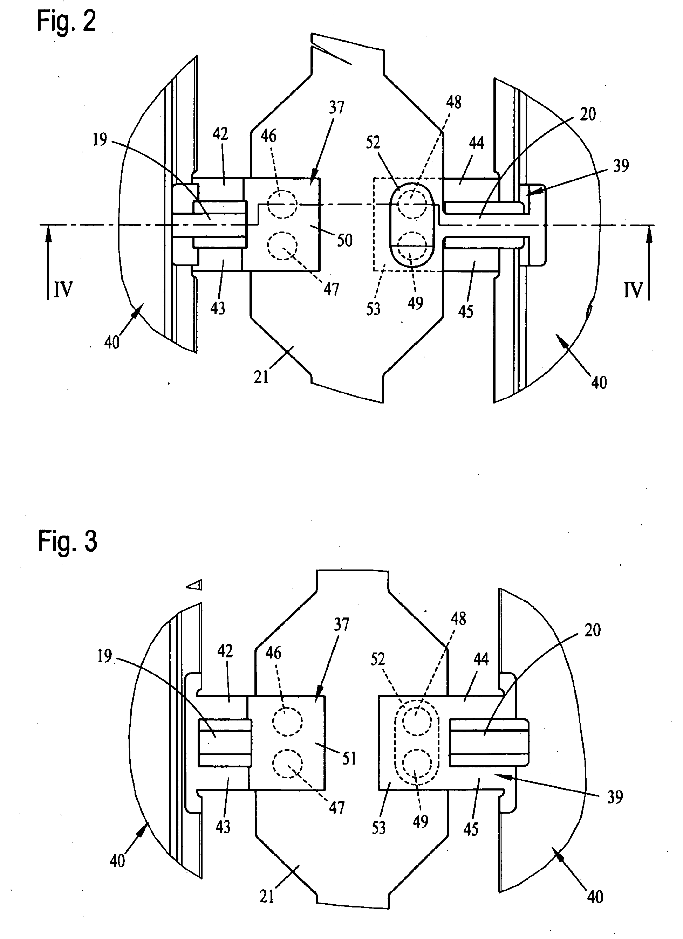

Fig. 2 zeigt hierzu einen vergrößerten Ausschnitt II aus Fig. 1 mit den beiden Haltestegen 19 und 20 sowie den zusätzlich an den beiden Kunststoffgehäusen 24 zweier benachbarter Hybridbauteile 40 angespritzten Kunststoffbrücken 37 und 39. Es ist erkennbar, dass die Kunststoffbrücken 37 und 39 jeweils zwei parallel zum jeweiligen Haltesteg 19 und 20 verlaufende Brückenabschnitte 42 und 43 bzw. 44 und 45 aufweisen, welche einerseits am jeweiligen Kunststoffgehäuse 24 angespritzt sind und zur zwischen den beiden Hybridbauteilen 40 angeordneten Quertraverse 21 des Stanzgitters 1 führen, welche ebenfalls aus Fig. 1 erkennbar sind.

Im Bereich der Brückenabschnitte 42 und 43 bzw. 44 und 45 der Kunststoffbrücken 37 und 39 weist die Quertraverse 21 jeweils zwei Durchbrüche 46 und 47 bzw. 48 und 49 auf (siehe auch Fig. 1), durch welche eine feststehende Verbindung der Kunststoffbrücken 37 und 39 mit den beiden benachbarten Quertraversen 21 herstellbar ist.

Fig. 3 zeigt eine Unteransicht der Verbindung aus Fig. 2. Einerseits ist aus Fig. 2 erkennbar, dass die linke Kunststoffbrücke 37 im Bereich der Quertraverse 21 eine oberseitige Halteplatte 50 aufweist. Dieser Halteplatte 50 ist unterseitig, wie aus Fig. 3 ersichtlich ist, eine zweite Halteplatte 51 zugeordnet, welche über die zugehörigen Durchbrüche 46 und 47 miteinander in Verbindung stehen. Somit ist erkennbar, dass das Hybridbauteil 40 über die Kunststoffbrücke 37 und deren beiden Halteplatten 50 und 51 über die entsprechend zugehörigen Brückenabschnitte 42 und 43 feststehend mit der Quertraverse 21 verbunden ist.

Die Ausgestaltung der zweiten Kunststoffbrücke 39 ist gegenüber der Haltebrücke 37 leicht modifiziert. So ist oberseitig im Bereich der beiden Durchbrüche 48 und 49 lediglich eine Kunststoffplatte 52 angespritzt, welche mit den beiden Brückenabschnitten 44 und 45 nicht direkt in Verbindung steht. Diese Kunststoffplatte 52 ist beim vorliegenden Ausführungsbeispiel als Oval ausgebildet und deckt die beiden Durchbrüche 48 und 49 ab. Unterseitig, ist an den beiden Brückenabschnitten 44 und 45, wie dies aus Fig. 3 ersichtlich ist, ebenfalls eine Halteplatte 53 angespritzt, welche die beiden Durchbrüche 48 und 49 abdeckt. Die Kunststoffplatte 52 ist dabei durch die beiden Durchbrüche 48 und 49 mit der Halteplatte 53 verbunden, so dass die Halteplatte 53 feststehend mit der Quertraverse 21 in Verbindung steht.

Die beiden Kunststoffbrücken 36 und 38 aus Fig. 1 sind identisch ausgebildet wie die in den Figuren 2 und 3 beschriebenen Kunststoffbrücken 37 und 39.

Erfindungsgemäß ist vorgesehen, dass nach dem Anspritzen des Kunststoffgehäuses 24 mit seinen Kunststoffbrücken 36, 37, 38 und 39 sowohl die Stabilisierungsstege 6 bis 16 (Fig. 1) als auch die Haltestege 17 bis 20 beispielsweise in einer Stanzvorrichtung durchtrennt werden. Damit werden auch die elektrischen Verbindungen zwischen den Verbindungselementen 2 bis 5 einerseits und zwischen den Verbindungselementen 2 bis 5 und den benachbarten Quertraversen 21 elektrisch getrennt. Nun kann das Hybridbauteil 40 mit seinen Verbindungselementen 2 bis 5 zusammen mit dem Stanzgitter 1 einer Spannungsprüfeinrichtung zugeführt werden.

Nachdem die Spannungsprüfung vollzogen ist, können durch Trennen der Kunststoffbrücken 36, 37, 38 und 39 die Hybridbauteile 40 aus dem Stanzgitter 1 herausgetrennt werden, so dass nunmehr das fertige Hybridbauteil 40 vorliegt.

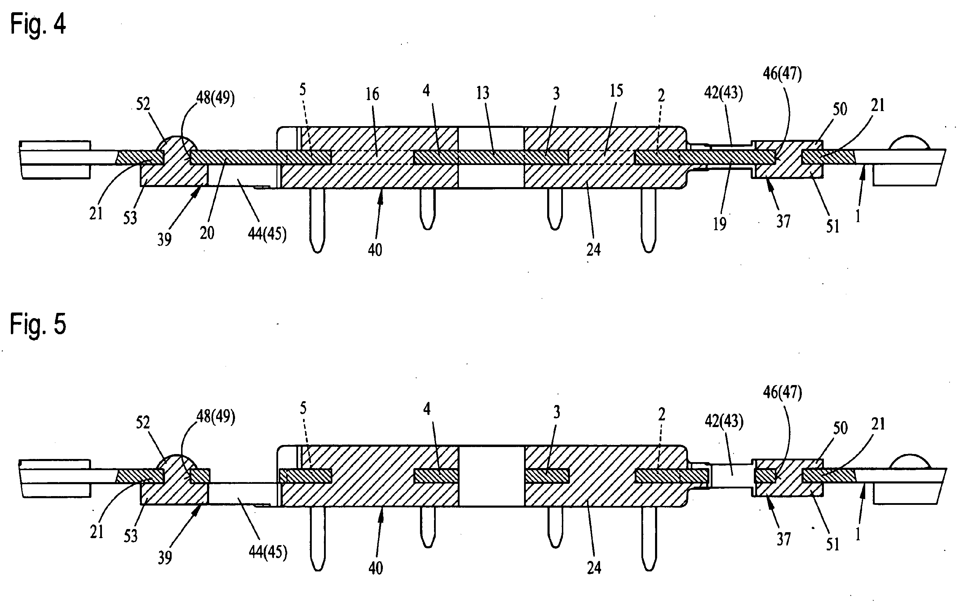

Fig. 4 zeigt einen Vertikalschnitt durch das linke Hybridbauteil 40 aus Fig. 1 entlang der Trennlinie IV-IV, wobei der genaue Schnittverlauf durch die beiden Kunststoffbrücken 37 und 39 entlang der Schnittlinie IV-IV aus Fig. 2 geführt ist. Weiter sind aus Fig. 4 die vier Verbindungselemente 2, 3, 4 und 5 erkennbar, welche u.a. über die Stabilisierungsstege 13, 15 und 16 feststehend miteinander in Verbindung stehen. Auch ist die Verbindung der beiden äußeren Verbindungselemente 2 und 5 über die beiden Haltestege 19 und 20 mit der jeweils benachbarten Quertraverse 21 des Stanzgitters 1 erkennbar. Das Kunststoffgehäuse 24 des Hybridbauteils 40 steht über die beiden Brückenabschnitte 42 und 43 mit der Halteplatte 51 der Kunststoffbrücke 37 in Verbindung, welche ihrerseits wiederum etwa in der Ebene des Stanzgitters 1 bzw. der Quertraverse 21 angeordnet ist. Oberseitig ist im Bereich der Quertraverse 21 und deren Durchbrüche 46 und 47 die Kunststoffplatte 50 angeordnet, welche wiederum feststehend mit der Halteplatte 51 verbunden ist. Beim vorliegenden Ausführungsbeispiel sind die Brückenabschnitte 42 und 43 in der Ebene des Stanzgitters 1 angeordnet.

Des weiteren, wie aus den Figuren 2 und 3 erkennbar ist, sind die beiden Brückenabschnitte 42 und 43 seitlich neben dem zugehörigen Haltesteg 19 angeordnet. Somit ist der Haltesteg 19 durch ein entsprechendes Stanzwerkzeug in einfacher Weise von unten nach oben ausstanzbar, so dass die Verbindung vom Verbindungselement 2 zum Stanzgitter 1 bzw. dessen Quertraverse 21 aufgehoben ist. In gleicher Art und Weise können gleichzeitig beim Ausstanzen des Haltesteges 19 auch der Haltesteg 20 sowie die Stabilisierungsstege 13, 15 und 16 sowie die weiteren in Fig. 4 nicht erkennbaren Haltestege 17 und 18 bzw. Stabilisierungsstege 6 bis 12 und 14 ausgestanzt werden.

Aus Fig. 4 ist weiter ersichtlich, dass die Kunststoffbrücke 39 mit ihrer Halteplatte 53 und ihrer Kunststoffplatte 52 auf der linken Seite an der zweiten Quertraverse 21 des Stanzgitters 1 festgelegt ist. Auch ist erkennbar, dass die Halteplatten 53 und die Kunststoffplatte 52 durch die Durchbrüche 48 und 49 einstückig miteinander verbunden sind.

Die beiden Brückenabschnitte 44 und 45 verbinden dabei die Halteplatte 53 mit dem Kunststoffgehäuse 24 des Hybridbauteils 40. Dabei ist aus Fig. 4 weiter ersichtlich, dass die beiden Brückenabschnitte 44 und 45 unterhalb des in der gleichen Horizontalebene parallel zum Haltesteg 20 verlaufenden Stanzgitters 1 angeordnet sind. Dabei weisen diese beiden Brückenabschnitte 44 und 45 jeweils einen seitlichen Abstand zum Haltesteg 20 auf, wie dies aus den Fig. 2 und 3 ersichtlich ist. Das heißt, dass beim nachfolgenden Stanzvorgang zum Durchtrennen des Haltesteges 20 dieser von unten mittels eines entsprechenden Stanzwerkzeuges in einfacher Weise zugänglich ist.

Fig. 5 zeigt die Darstellung aus Fig. 4 nach dem Stanzvorgang. Es ist erkennbar, dass im Bereich der Brückenabschnitte 42 und 43 bzw. 44 und 45 die in Fig. 4 dargestellten Haltestege 19 und 20 entfernt sind. Des weiteren wurden auch die Stabilisierungsstege 13, 15 und 16 aus Fig. 4 entfernt. Durch diesen Verfahrensabschnitt sind somit die vier Verbindungselemente 2, 3, 4 und 5 getrennt voneinander und gleichzeitig auch getrennt von den benachbarten Quertraversen 21 des Stanzgitters 1.

Damit kann das Hybridbauteil 40 mit seinem Kunststoffgehäuse 24 und der darin eingebetteten Verbindungselemente 2 bis 5 einer nachfolgenden Spannungsprüfung zugeführt werden. Da die Hybridbauteile 40 weiterhin durch die Kunststoffbrücken 36 bis 39 in das Stanzgitter 1 feststehend eingebettet sind, kann auch diese Zuführung zu einer Spannungsprüfeinrichtung weiter in einem kontinuierlichen Arbeitsvorgang erfolgen, ohne dass dazu eine Handhabungseinrichtung in Form beispielsweise eines Industrieroboters notwendig ist. Nachdem diese Spannungsprüfung beendet wurde, können nun die Kunststoffbrücken 36, 37, 38 und 39 beispielsweise durch einen weiteren Stanzvorgang abgetrennt werden, so dass das Hybridbauteil 40 in seinem endgültigen Fertigungszustand als separates und einsatzbereites Bauteil vorliegt.

Es ist erkennbar, dass durch das beschriebene Herstellungsverfahren mit dem Anspritzen der Kunststoffbrücken 36 bis 39 an das Kunststoffgehäuse 24 sämtliche, das Hybridbauteil 40 betreffende nachfolgenden Arbeitsvorgänge in einem kontinuierlichen Arbeitsprozess durchführbar sind, da die Hybridbauteile 40 über das Stanzgitter 1 in einem kontinuierlichen Transport den jeweiligen, aufeinander folgenden Arbeitsmaschinen zuführbar sind.

Insbesondere ist die Spannungsprüfung der einzelnen Verbindungselemente 2, 3, 4, 5 bzw. des Hybridbauteiles 40 ebenfalls in einem kontinuierlichen Arbeitsprozess durchführbar, da die Hybridbauteile 40 durch die Kunststoffbrücken 36 bis 39 im Stanzgitter 1 verbleiben. Damit kann insbesondere eine Handhabungseinrichtung insbesondere in Form eines Industrieroboters zur Bestückung der Trenn- oder Stanzeinrichtung zum Trennen der Stabilisierungsstege oder zur Bestückung der Spannungsprüfeinrichtung entfallen, so dass der Herstellungsprozess erheblich vereinfacht und damit kostengünstiger wird.

Die Anordnung der zusätzlichen Kunststoffbrücken muss dabei nicht zwingend im Bereich der Haltestege erfolgen. Solche Kunststoffbrücken können auch an anderer Stelle und auch in anderer Anzahl vorgesehen werden. Es muss lediglich gewährleistet sein, dass das Hybridbauteil mit seinem Gehäuse feststehend im Stanzgitter verbleibt, so dass dieses bandförmig mit den Hybridbauteilen den einzelnen Arbeitsmaschinen zuführbar ist.

## Patentansprüche

1. Verfahren zur Herstellung eines elektrischen Hybridbauteils (40), welches als elektrische Leiter aus einem Stanzgitter (1) ausgestanzte Verbindungselemente (2, 3, 4, 5) aufweist, welche mit einem Kunststoffgehäuse (24) umspritzt sind, wobei die Verbindungselemente (2, 3, 4, 5) zumindest vor dem Umspritzen untereinander mit Stabilisierungsstegen (6, 7, 8, 9, 10, 11, 12, 13, 14, 15, 16) verbunden sind und mit dem Stanzgitter (1) über Haltestege (17, 18, 19, 20) feststehend in Verbindung stehen, wobei das Stanzgitter (1) bandförmig ausgebildet ist und nach dem Stanzvorgang mehrere in einer Transportrichtung (Pfeil 23) hintereinander liegende Gruppen von Verbindungselementen (2 bis 5) bildet und wobei das Stanzgitter (1) zusammen mit den mit dem Stanzgitter (1) in Verbindung stehenden Verbindungselementen (2, 3, 4, 5) und mit Ausnahme der Stabilisierungsstege (6, 7, 8, 9, 10, 11, 12, 13, 14, 15, 16) in einem Spritzgussvorgang gemeinsam mit einem Kunststoffgehäuse (24) umspritzt wird und, wobei am Kunststoffgehäuse (24) wenigstens zwei Kunststoffbrücken (36, 37, 38, 39) angespritzt werden, über welche das angespritzte Kunststoffgehäuse (24) mit dem Stanzgitter (1) zusätzlich verbunden wird.

2. Verfahren nach Anspruch 1, **dadurch gekennzeichnet, dass** die Kunststoffbrücken (36, 37, 38, 39) im Bereich der Haltestege (17, 18 ,19, 20) angespritzt werden.

3. Verfahren nach Anspruch 1 oder 2, **dadurch gekennzeichnet, dass** das Stanzgitter (1) zusammen mit dem aus den Verbindungselementen (2, 3, 4, 5) und dem Kunststoffgehäuse (24) bestehende Hybridbauteil (40) einer Trenn- oder Stanzeinrichtung zugeführt wird und,
dass durch die Trenn- oder Stanzeinrichtung die Haltestege (17, 18, 19, 20) elektrisch getrennt werden.

4. Verfahren nach Anspruch 3, **dadurch gekennzeichnet, dass** durch die Trenn- oder Stanzeinrichtung die Verbindungselemente (2, 3, 4, 5) durch Trennung der Stabilisierungsstege (6, 7, 8, 9, 10, 11, 12, 13, 14, 15, 16) voneinander elektrisch getrennt werden.

5. Verfahren nach Anspruch 4, **dadurch gekennzeichnet, dass** die Trennung der Haltestege (17, 18, 19, 20) und der Stabilisierungsstege (6, 7, 8, 9, 10, 11, 12, 13, 14, 15, 16) gleichzeitig in einem Arbeitsschritt erfolgt.

6. Verfahren nach Anspruch 5, **dadurch gekennzeichnet, dass** das Stanzgitter (1) zusammen mit dem Hybridbauteil (40) einer elektrischen Spannungsprüfeinrichtung zugeführt wird, in welcher das Hybridbauteil (40) auf Spannungsüberschläge geprüft wird.

7. Verfahren nach Anspruch 6, **dadurch gekennzeichnet, dass** nach der Spannungsprüfung das Hybridbauteil (40) durch Trennung der Kunststoffbrücken (36, 37, 38, 39) vom Stanzgitter (1) separiert wird.

## Claims

1. Method for producing electric hybrid components (40) that features punch scrap (1) punched connexion elements (2, 3, 4, 5) in its function as electric conductor. Those connexion elements are extrusion-coated with a plastic body (24), whereas the connexion elements (2, 3, 4, 5) are mutually linked via stabilisation bridges (6, 7, 8, 9, 10, 11, 12, 13, 14, 15, 16) at least prior to extrusion-coating, whereas they are firmly linked to the punch scrap (1) via support bridges (17, 18, 19, 20), whereas the punch scrap (1) is linear and forms several groups of connexion elements (2 to 5) arranged in a row inside a transport facility (arrow 23), whereas the punch scrap (1) linked to the punch scrap-linked connexion elements (2,3,4,5)-and with the exception of the stabilisation bridges (6, 7, 8, 9, 10, 11, 12, 13, 14, 15, 16) -is extrusion-coated together with the plastic body (24) in a single process, whereas at least two plastic bridges ( 36, 37, 38, 39) are sprayed onto the plastic body (24) via which the sprayed-on plastic body (24) will be additionally linked with the punch scrap (1).

2. Method according to Claim 1, **characterised in that** the plastic bridges (36, 37, 38, 39) are sprayed on in the area of the support bridges (17, 18, 19, 20).

3. Method acc. to Claims 1 or 2, **characterised in that** the punch scrap (1) is forwarded to a separation or punching device together with the connexion elements (2, 3, 4, 5) and the hybrid component (40) consisting of the plastic body (24). It is furthermore **characterised by** an electronic separation of the support bridges (17, 18, 19, 20) due to the separation and punching device.

4. Method acc. to Claim 3, **characterised in that** the separation and punching device electrically separates the connexion elements (2, 3, 4,5) due to the separation of the stabilisation bridges (6, 7, 8, 9, 10, 11, 12, 13, 14, 15, 16).

5. Method acc. to Claim 4, **characterised in that** the separation of the support bridges (17, 18, 19, 20) and the stabilisation bridges (6, 7, 8, 9, 10, 11, 12, 13, 14, 15, 16) occurs simultaneously in one step.

6. Method acc. to Claim 5, **characterised in that** the punch scrap (1) is exposed to an electric voltage test facility alongside the hybrid component (40), where the hybrid part (40) is tested with regard to voltage flashovers.

7. Method acc. to Claim 6, **characterised in that** upon voltage test, the hybrid component (40) will be separated from the punch scrap (1) due to the separation of the plastic bridges (36, 37, 38, 39).

## Revendications

1. Procédé de fabrication d'un composant hybride (40) électrique, lequel comprend
le matriçage d'éléments de connexion (2, 3, 4, 5) servant de conducteurs électriques à partir d'une grille estampée (1), lesdits éléments de connexion étant surmoulés avec un boîtier en plastique (24), sachant que ces mêmes éléments de connexion (2, 3, 4, 5) sont reliés entre eux par des nervures de stabilisation (6, 7, 8, 9, 10, 11, 12, 13, 14, 15, 16), au moins avant le surmoulage, et qu'ils sont reliés fixement à ladite grille estampée (1) par des nervures de maintien (17, 18, 19, 20), sachant que la grille estampée (1) est en forme de bande et constitue, après l'opération d'estampage, plusieurs groupe d'éléments de connexion (2 à 5) disposés à l'horizontale l'un derrière l'autre dans un dispositif de transport (flèche 23) et sachant que la grille estampée (1) avec un boîtier en plastique (24) est surmoulée au cours d'une opération de moulage par injection avec les éléments de connexion (2, 3, 4 5) liés à ladite grille estampée (1), à l'exception des nervures de stabilisation (6, 7, 8, 9, 10, 11, 12, 13, 14, 15, 16), et sachant que sur le boîtier en plastique (24), au moins deux ponts en plastique (36, 37, 38, 39) sont moulés par injection, par le biais desquels le boîtier moulé par injection (24) possède une liaison supplémentaire à la grille estampée (1).

2. Procédé selon la revendication 1, **caractérisé en ce que** les ponts en plastique (36, 37, 38, 39) sont moulés par injection dans la zone des nervures de maintien (17, 18, 19, 20).

3. Procédé selon la revendication 1 ou 2, **caractérisé en ce que** la grille estampée (1) est amenée, avec le composant hybride (40) constitué des éléments de connexion (2, 3, 4, 5) et du boîtier en plastique (24), au dispositif de séparation ou d'estampage et que les nervures de maintien (17, 18, 19, 20) sont séparées électriquement par le dispositif de séparation ou d'estampage.

4. Procédé selon la revendication 3, **caractérisé en ce que** les éléments de connexion (2, 3, 4, 5) sont séparés électriquement les uns des autres par séparation des nervures de stabilisation (6, 7, 8, 9, 10, 11, 12, 13, 14, 15, 16) dans le dispositif de séparation ou d'estampage.

5. Procédé selon la revendication 4, **caractérisé en ce que** la séparation des nervures de maintien (17,18, 19, 20) et des nervures de stabilisation (6, 7, 8, 9, 10, 11, 12, 13, 14, 15, 16) est effectuée simultanément en une seule étape.

6. Procédé selon la revendication 5, **caractérisé en ce que** la grille estampée (1) est transférée avec le composant hybride (40) à un dispositif de test de la tension électrique, dans l'objectif de contrôler la formation d'étincelles de tension électrique sur le composant hybride (40).

7. Procédé selon la revendication 6, **caractérisé en ce qu'**après le test de la tension, le composant hybride (40) est séparé de la grille estampée (1) par séparation des ponts en plastique (36, 37, 38, 39).
